Europäisches Patentamt

(19) European Patent Office

Office européen des brevets

(11) Publication number: **0 235 907 B1**

(12) **EUROPEAN PATENT SPECIFICATION**

(45) Date of publication of patent specification: **31.03.93** (51) Int. Cl.⁵: **G01R 31/02**, G01N 21/59

(21) Application number: **87300599.5**

(22) Date of filing: **23.01.87**

(54) **Harness integrity tester (HIT).**

(30) Priority: **24.01.86 US 822212**

(43) Date of publication of application:
**09.09.87 Bulletin 87/37**

(45) Publication of the grant of the patent:
**31.03.93 Bulletin 93/13**

(84) Designated Contracting States:
**BE DE FR GB IT NL SE**

(56) References cited:
**EP-A- 0 008 954**
**EP-A- 0 164 570**
**FR-A- 2 439 397**
**US-A- 4 224 690**

**PATENT ABSTRACTS OF JAPAN, volume 6,
no. 30, (P-103)(908), 23 February 1982; & JP-
A-56150323**

**PATENT ABSTRACTS OF JAPAN, volume 10,
no. 132 (P-456)(2189), 16 May 1986; & JP-
A-60253947**

(73) Proprietor: **Sullivan, Thomas P.
10427 W. Calle de Plata
Phoenix Arizona 85039(US)**

(72) Inventor: **Sullivan, Thomas P.
10427 W. Calle de Plata
Phoenix Arizona 85039(US)**

(74) Representative: **MacGregor, Gordon et al
ERIC POTTER & CLARKSON St. Mary's Court
St. Mary's Gate
Nottingham, NG1 1LE (GB)**

EP 0 235 907 B1

**Description**

This invention pertains to a method and apparatus for determining the conductive integrity of a plurality of lines which transmit electromagnetic radiation.

More particularly, the invention is useful for a method and apparatus for determining the conductive integrity of multiple wire cables or harnesses which line the fuselage and wings of sophisticated modern day jet aircraft.

The fuselage and wings of sophisticated modern aircraft are lined with multiple wire cables. The cost, both in terms of manpower and equipment, involved in the conventional process of troubleshooting defective cable is substantial.

Therefor, it is a principle object of the invention as defined in claims 1 and 2 respectively to provide an improved method and apparatus for determining the conductive integrity of aircraft harnesses and of bundles of electromagnetic radiation transmission lines in general. Such a known method and apparatus, defined by the precharacterizing features of claims 1 and 2, are known from US-A-4 224 690.

This and other, further and more specific objects and advantages of the invention will be apparent to those skilled in the art from the following detailed description thereof, taken in conjunction with the drawings, in which:

Fig. 1 is a top view illustrating an aircraft harness attached to apparatus constructed in accordance with the invention;

Fig. 2 is a top view illustrating an aircraft harness attached to testing apparatus of the invention;

Fig. 3 is a top view illustrating a severed aircraft harness attached to testing apparatus of the invention;

Fig. 4 is a schematic diagram illustrating the control unit of the invention; and

Fig. 5 is a schematic diagram illustrating the detector unit of the invention.

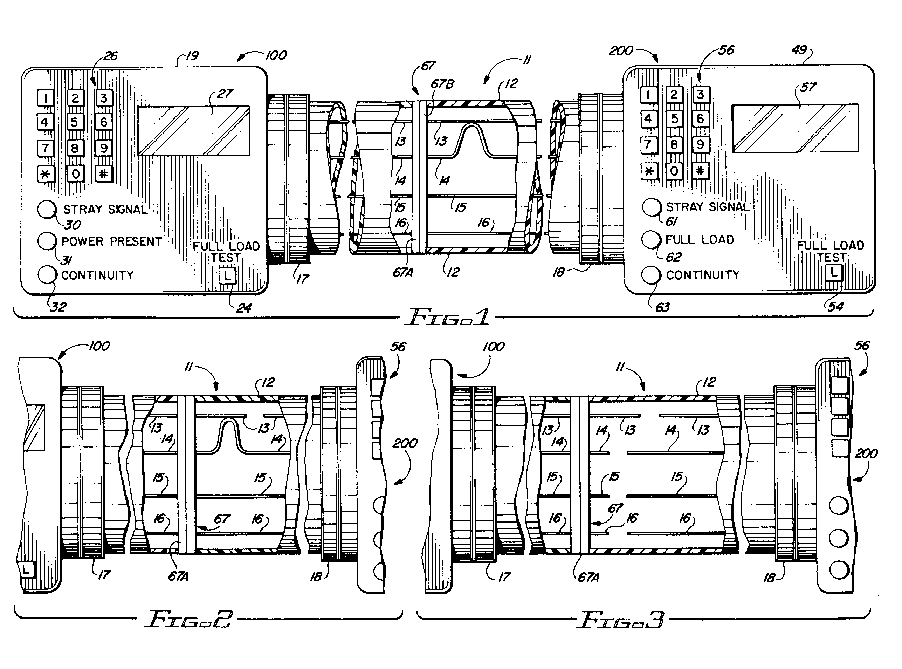

Turning now to the drawings, which depict the presently preferred embodiments of the invention for the purpose of illustrating the practice thereof and not by way of limitation of the scope of the invention, Figs. 1-5 illustrate apparatus for testing the conductive integrity of lines for transmitting electromagnetic radiation such as cosmic-ray photons, gamma rays, x-rays, ultraviolet radiation, visible light, infrared radiation, microwaves, radio waves, heat and electric current. Cable 11 includes insulative sheathing 12 circumscribing transmission lines or electrically conductive wires 13, 14, 15 and 16 which extend the length of line 11. Each wire 13-16 has a first end and a second end. The first end is secured to and includes connector unit 17. The second end is secured to and includes connector unit 18. Connector unit 17 typically comprises a cannon plug having a pin or pin socket attached to each wire 13-16. For purposes of this description, it is assumed connector unit 17 is a cannon plug having a pin socket 17A attached to each wire 13-16. Connector unit 18 also typically comprises a cannon plug having a pin or pin socket attached to each wire 13-16. For purposes of this description, it is assumed connector unit 18 is a cannon plug having a pin socket 18A attached to each wire 13-16. The control unit (CU) of the testing apparatus of the invention is generally designated by reference character 100 and includes a housing 19 carrying microprocessor 20, switching unit 21, sensor unit 22, power source 23, spring-loaded full load button 24, display lights 25, push button keyboard 26, LED readout 27 and connector means adapted to securely interfit with the existing cannon plug 17 of wire 11 to provide a stable measuring environment and to duplicate the desired continuity of connection between plug 17 and a mating connector unit. As utilized herein, the term "continuity of connection" refers to the losses in electromagnetic radiation which occur when the electromagnetic radiation moving through a line travels through a connection or juncture such as a pin--pin socket connection. The connections offering the best continuity of connection are those which cause the smallest loss of electromagnetic radiation when the radiation travels through the connection. The connector means of the control unit includes pins 28 shaped and dimensioned to slidably interfit into pin sockets 17A of cannon plug 17. Each pin 28 is connected to one of wires 13A, 14A, 15A, 16A leading to sensor unit 22. Wires 13B, 14B, 15B, 16B interconnect switching unit 21 and sensor unit 22. Wires 13A-16A receive electromagnetic radiation signals entering control unit (CU) 100 through connectors 17A, 28 from wires 13-16, respectively. Electromagnetic radiation entering sensor unit 22 through wires 13A -16A exits through wires 13B-16B, respectively. Keyboard 26 includes twelve spring loaded buttons labelled in the same manner as the twelve push buttons on a conventional telephone. Each of the spring loaded buttons on the CU 100 is normally maintained in an "OFF" position. When a button in keyboard 26 is depressed a signal 29 to microprocessor 20 is generated. As soon as finger pressure on a button in keyboard 26 is released, the button moves upwardly to its normal "OFF" position. Full Load Test button 24 is also spring loaded and is normally in an "OFF" position. Depressing button 24 displaces it to the "ON" position. Once finger pressure on button 24 is released, the button moves upwardly to its normal "OFF" position. The display lights 25 include red stray signal indicator 30, green power present indicator 31, and amber continuity

EP 0 235 907 B1

indicator 32. Display lights 25 are controlled 33 by microprocessor 20. When Full Load Test button 24 is depressed and held for two seconds it causes a signal 32 to be sent to microprocessor 20. LED readout 27 produces an alphanumeric readout on command 35 from microprocessor 20. Power source 23 is presently preferably a battery internally mounted inside housing 19 of CU 100. However, power can be supplied to CU 100 by any other appropriate internal or external source. Microprocessor 20 receives signals 36 from monitoring circuitry inside power source 23 indicating the operational status of source 23 and its ability to deliver to switching unit 21 the quantity of power required by microprocessor 20. Microprocessor 20 controls 38 the amount of power transmitted 37 by power source 23 to switching unit 21. When a particular wire 13-16 is selected for continuity testing by depressing the appropriate buttons in keyboard 26, microprocessor 20 commands 39 switching unit 21 such that power 37 from source 23 is directed through switching unit 21 and onto the wire 13-16 selected at keyboard 26. Sensor unit 32 provides 40 microprocessor 20 with data indicating the quantity or other physical characteristic which indicates either the quantity and/or quality of the electromagnetic radiation traveling along wires 13-16.

The detector unit (DU) of the testing apparatus of the invention is generally designated by reference character 200 and includes a housing 49 carrying microprocessor 50, sensor unit 52, spring-loaded Full Load Test button 54, display lights 55, push button keyboard 56, LED readout 57, and connector means adapted to securely interfit with the cannon plug 18 or wire 11 to provide a stable measuring environment and to provide the desired continuity of connection with plug 18. The connector means of the detector unit (DU) 200 includes pins 59 shaped and dimensioned to slidably interfit into pin sockets 18A of cannon plug 18. Each pin 59 is connected to one of wires 13C, 14C, 15C, 16C leading to sensor unit 52. Wires 13C, 14C, 15C, 16C receive electromagnetic radiation entering DU 200 through connectors 18, 59 from wires 13-16, respectively. Electromagnetic radiation entering sensor unit 52 through wires 13C-16C exits sensor unit 52 through wires 13D-16D, respectively. Wires 13D-16D interconnect sensor unit 52 and switching unit 69. Microprocessor 20 controls 70 switching unit 69. Keyboard 56 includes twelve spring loaded buttons labelled in the same manner as the twelve buttons on a conventional push button telephone. Each of the DU push buttons is normally in the "OFF" position. When a push button in keyboard 56 is depressed, a signal 60 to microprocessor 50 is generated. As soon as finger pressured on a push button in keyboard 56 is released, the button moves upwardly to its normal "OFF" position. Full Load Test button 54 is also spring loaded and is normally in an "OFF" position. Depressing button 54 displaces it to the "ON" position. Once finger pressure on button 54 is released, the button moves upwardly to its normal "OFF" position. Display lights 55 include red stray signal indicator 61, green full load indicator 62, and amber continuity indicator 63. Display lights 55 are controlled 68 by microprocessor 50. When Full Load Test button 54 is depressed and held for two seconds, it causes a signal 64 to be sent to microprocessor 50. LED readout 57 produces an alphanumeric readout on receiving a command 65 from microprocessor 50. When a particular wire 13-16 is selected for testing by making the appropriate entry on keyboard 56, microprocessor 50 receives signals 66 from sensor unit 52 indicating either the quantity or other physcial characteristics which indicate the quantity or other physical characteristics which indicate the quantity and/or quality of electromagnetic radiation passing through wire 13-16.

The operation of the apparatus of the invention is, with reference to Figs. 1 to 3, further illustrated below in TABLES I-III. For purposes of the troubleshooting procedures described below in TABLES I-III it is assumed the cable 11 in Figs. 1 to 3 is in a present day jet aircraft, includes at least one bulkhead connector 67 therein, has a first end including cannon plug 17, and has a second end including cannon plug 18.

Prior to the testing procesures of TABLES I-III, cannon plugs 17, 18 are disconnected from their mating connectors in the aircraft and are connect to connector means of the CU 100 and DU 200, respectively in the manner depicted in Fig. 1. The mating connectors of plugs 17, 18 in the aircraft are typically associated with a computer or LRU. The connector means in CU 100 and DU 200 are essentially a duplicate of the aircraft mating connectors and each include four pins which each slidably interfit with one of the four pin sockets of plug 17 or plug 18 to provide a connection with plugs 17, 18 which produces a high continuity of connection and causes minimal losses of electromagnetic radiation when radiation from wire 13-16 travels through the pin--pin socket connections into or from CU 100 or DU 200.

In TABLES I-III reference is made to alphanumeric readouts on the CU LED readout 27 and the DU LED readout 57. The meaning of these readouts is as follows:

3

| Readout | Meaning |
|---------|---------|
| PT | Pin test |
| DS | Dead short |
| SS | Stray signal |
| SP | Signal present |
| FL | Full load |

When numerals appear in the readouts, the numerals indicate the wire associated with the particular letter readout. Letter readouts generally always occur in conjunction with a numerical readout. For example, "PT 13" means wire 13 is being tested; "SS 14" means there is a stray signal (short) on wire 14; "SP 15" means there is a signal present on wire 15.

TABLE I

Test Procedure for Cable 11 of Fig. 1. Wires 13-16
Continuous and Wire 14 Shorted to Wire 13

Step 1:     To test wire 13, the "1" and "3" buttons are sequentially depressed on keyboard 26 of CU 100. When the "1" and "3" buttons are depressed, signal 29 is received by microprocessor 20 which commands 38 power source 23 to send 37 a small current, typically three to thirty milliamps (ma), to switching unit 21. Microprocessor 20 also commands 39 switching unit 21 to direct the small current over line 13B. The signal directed onto line 13B by unit 21 passes through sensor unit 22, line 13A, connectors 28 and 17A, and into wire 13.

Step 2:     As part of the procedure for testing wire 13, the "1" and "3" buttons are sequentially depressed on keyboard 56 of detector unit (DU) 200. When the "1" and "3" buttons are depressed, signal 60 is received by microprocessor 50. The small current directed into wire 13 by CU 100 travels along wire 13, through connectors 18A and 59, and into sensor unit 52. The short of wire 14 to wire 13 permits the signal from line 13 to travel through wire 14 and connectors 18A and 59 into wire 14C and sensor unit 52. The signal passing through wire 14 also travels

through connectors 17A and 28 into line 14A and sensor unit 22. Signal 66 from sensor unit 52 to DU microprocessor 50 indicates that small currents are flowing through lines 13C and 14C and that no current is passing through lines 15C and 16C. Sensor unit 22 of CU 100 informs 40 microprocessor 20 that a small current is flowing through lines 13A and 14A and that no current is passing through lines 15A and 16A. After receiving the afore-mentioned data, micro-processors 20 and 50 direct 35, 65 LED readouts 27 and 57, respectively, and direct 33, 68 display lights 25, 55 to read as indicated below.

a. Readings on control (CU) 100,

(1)     LED readout 27 reads, in sequence: "PT 13", "SS 14". There are no readouts pertaining to wires 15 and 16 because sensor unit 22 does not detect any current flowing through wires 15A and 16A.

(2)     Red indicator light 30 is on because of the signal received by the CU over line 14A. Microprocessor 20 knows wire 13 is being tested. Accordingly, when sensor unit 22 detects the flow of current through wire 14A, microprocessor 20 knows there is a stray signal in wire 14A and that wire 14 is shorted to wire 13. Microprocessor consequently causes red indicator light 30 to illuminate.

(3)     Green indicator light 31 is on because internal power source 23 circuitry indicates

36 to microprocessor 20 that power source 23 is in the proper oeprative condition and is delivering a small three to thirty ma current to switching unit 21.

(4)     Amber indicator light 32 is off because there is no built-in jumper connection in cannon plug 17 between wire 13 and one of the other wires. If there were a built-in jumper connection, say between wire 13 and wire 15, this information would be programmed into microprocessor 20 which would, on receiving an indication 40 from sensor unit 22 that current was passing through wire 15A when current was directed through wire 13A,

(a)     command 33 amber indicator light 32 to illuminate, and

(b)     command 35 the LED readout 27 to read, in sequence: "PT 13", "SS 14", "SP 15".

(5)     The Full Load Test button 24 is in the "OFF" position because a full load test is not being performed.

b. Readings on detector unit (DU) 200:

(1)     LED readout 57 reads, in sequence: "SP 13, SS 14". There are no readouts pertaining to wires 15 and 16 because sensor unit 52 does not detect any current flowing through wires 15C and 16C.

(2)     Red indicator light 61 is on because of current flow detected by sensor unit 52 over line 14C. Microprocessor 50 knows wire 13 is being tested. Accordingly, when sensor unit 52 detects the flow of current through wire 14C, microprocessor 50 knows there is a

7

stray signal in wire 14C and that wire 14 is shorted to wire 13. Microprocessor 50 consequently causes red indicator light 61 to illuminate.

(3)     Amber indicator light 63 is on because of the signal in line 13C detected by sensor unit 52. When sensor unit 52 incidates 66 to microprocessor 50 that a current flow exists in wire 13C, microprocessor 50 commands the amber indicator light 63 to illuminate. Light 63 illuminates when there is a signal present in the wire being tested.

(4)     Green indicator light 62 is off because the full load test is not being performed.

(5)     The Full Load Test button 54 is in the "OFF" position because the full load test is not being performed. When the microprocessor 50 inhibits the DU from performing a full load check by not directing switching unit 69 to place a load, i.e., a resistance, on a wire 13D-16D to permit a larger current to be directed into the wire to test the load carrying capacity of the wire. If red indicator light 61 is on, then micro-processor 50 inhibits the performance of the full load test even when Full Load Test button 54 is depressed to the "ON" position.

RESULT:     Based on the above readings, the technician utilizing the testing equipment of the invention knows that wire 14 is shorted to wire 13 and that wires 13 and 14 have a minimal amount of conductive continuity and are not severed.

SUBSEQUENT MAINTENANCE PROCEDURE:     Remove and replace

cable 11; connect CU or DU at other points along length of cable to isolate short location, for instance, separate cable 11 at bulkhead connector 67, disconnect DU 200 from cannon plug 18, connect DU to bulkhead connector 67A, and repeat test of wire 13; or, after the "1" and "3" buttons are depressed on keyboards 26 and 56, move cable 11 at various points therealong to attempt to locate the short. If cable 11 is moved near the location of the short, wire 14 often momentarily separates from wire 13, causing the flow of current from wire 13 through wire 14 to stop. When the flow of current into wire 14C consquently stops, sensor unit 52 notifies microprocessor 50 which turns off 68 red indicator light 61. If light 61 turns off when cable 11 is moved at a particular point, then a technician(s) utilizing the CU and DU knows the location of the short.

NOTE: When the number of a wire being tested is entered into keyboard 26, 56 of CU 100 or DU 200, this information is maintained in the memory of microprocessors 20, 50 respectively, and that wire is the wire over which a small current, or, during the full load test, a larger current, is directed. The CU 100 will direct current over another wire only after a new number is entered in keyboard 26.

Step 3: The "1" and "5" buttons are sequentially depressed on keyboard 26 of CU 100. When the "1" and "5" buttons are depressed, signal 29 is received by microprocessor 20 which notes that wire 15 is being tested and commands 38 power source 23 to send 37 a small current, typically three to thirty milliamps (ma), to switching unit 21. Microprocessor 20 also

9

commands switching unit 21 to direct the small current over line 15B. The signal directed onto line 15B by unit 21 passes through sensor unit 22, line 15A, connectors 28 and 17A, and into wire 15.

Step 4: The "1" and "5" buttons are sequentially depressed on keyboard 56 or detector unit (DU) 200. When the "1" and "5" buttons are depressed, signal 60 is received by microprocessor 50, which notes that wire 15 is being tested. The small current directed into wire 15 by switching unit 21 of CU 100 travels along wire 15, through connectors 18A and 59, and into sensor unit 52. Signal 66 from sensor unit 52 to DU microprocessor 50 indicates that a small current is flowing through line 15C and that there is no current flowing through lines 13C, 14C and 16C. Sensor unit 22 of CU 100 informs microprocessor 20 that a small current is flowing through line 15A and that no current is flowing through lines 13A, 14A and 16A. After receiving the afore-mentioned data, microprocessors 20 and 50 direct 35, 65 LED readouts 27 and 57, respectively, and direct 33, 68 display lights 25, 55 to read as indicated below.

a. Readings on control unit (CU) 100:
(1) LED readout 27 reads, in sequence: "PT 15". There are no readouts pertaining to wires 13, 14, 16 because sensor unit 22 does not detect any current flowing through these wires.
(2) Red indicator light 30 is off because sensor

unit 22 does not detect any current flowing through wires other than wire 15. Microprocessor 20 knows wire 15 is being tested and should be transmitting a current.

(3) Green indicator light 31 is on.

(4) Amber indicator light 32 is off because there is no built-in jumper connection in cannon plug 17 between wire 13 and one of the other wires.

(5) The Full Load Test button 24 is in the "OFF" position.

b. Readings on detector unit (DU) 200:

(1) LED readout 57 reads, in sequence: "SP 15". There are no readouts pertaining to wires 13, 14 and 16 because sensor unit 52 does not detect any current flowing through wires 13C, 14C and 16C. Sensor unit 52 notifies 66 microprocessor 50 that there is no current flowing through wires 13C, 14C and 16C and, consequently, microprocessor 50 does not cause LED readout 57 to display any information concerning wires 13, 14 and 16.

(2) Red indicator light 61 is off because there is no current flow detected by sensor unit 52 over lines 13C, 14C and 16C. Sensor unit 52 notifies 66 microprocessor 50 that there is not current flowing through wires 13C, 14C and 16C and, consequently, microprocessor 50 does not cause LED readout 57 to display any information concerning wires 13, 14 and 16.

(3) Amber indicator light 63 is on because of the current flow in line 15C detected by sensor unit 52. When sensor unit 52 indicates 66 to microprocessor 50 that a

11

current flow exists in wire 15C, microprocessor 50 commands the amber indicator light 63 to illuminate. Light 63 illuminates when there is a signal present in the wire being tested.

(4)     Green indicator light 62 is off.

(5)     The Full Load Test button 54 is in the "OFF" position.

RESULT:     Based on the above readings resulting after Steps 3 and 4, the technician utilizing the testing equipment of the invention knows that wire 15 is not shorted to wires 13, 14 16 and that wire 15 at least has a minimal amount of conductive continuity, i.e., knows that wire 15 is not completely severed.

SUBSEQUENT MAINTENANCE PROCEDURE: Perform full load test described below in steps 5-8.

Step 5:     Depress the "#" button on keyboard 26. The "#" button must be depressed in order for microprocessor 20 to permit a full load test to be performed on wire 15.

Step 6:     Depress and hold the Full Load Test button 24 in the "ON" position. After the "#" button and button 24 are depressed, microprocessor 20 receives signals 29, 34 verifying that the "#" button has been pushed and that button 24 is being held in the "ON" position. Microprocessor 20 then commands power source 23 to provide switching unit 21 with a large current, typically three to ten amps. Microprocessor 20 also commands 39 switching unit 21 to direct the current from power source 23 over line 15B. The signal on line 15B passes through sensor unit 22, lines 15A,

EP 0 235 907 B1

connectors 28 and 17A, and into wire 15. This current signal travels through wire 15 to the DU 200.

Step 7:   Depress the "#" button on keyboard 56. The "#" button must be depressed in order for the microprocessor 50 to permit a full load test to be performed on wire 15.

Step 8:   Depress and hold the Full Load Test button 54 in the "ON" position. After the "#" button and button 54 are depressed, micro-processor 50 receives the signals 60, 64 verifying that the "#" button has been pushed and that button 54 is being held in the "ON" position. Microprocessor 50 then commands 70 switching unit 69 to place an appropriate load (resistance) on wire 15D to permit a full load test of wire 15. After Steps 5-8, microprocessors 20 and 50 direct 35, 65 LED readouts 27 and 57, respectively, and direct 33, 68 display lights 25, 55 to read as indicated below.

a. Readings on control unit (CU) 100:

(1)   LED readout 27 reads, in sequence: "FL 15".

(2)   Red indicator light 30 is off.

(3)   Green indicator light 31 is on.

(4)   Amber indicator light 32 is off.

(5)   The Full Load Test button 24 is in the "ON" position.

b. Readings on detector unit (DU) 200:

(1)   LED readout 57 reads, in sequent: "FL 15".

(2)   Red indicator light 61 is off.

(3)   Amber indicator light 63 is on.

(4)   Green indicator light 62 is on because the full load test is being performed and wire 15 is carrying the full load. Sensor unit 52

determines the voltage across wire 15. If, for example, the CU 100 is programmed to direct sufficient current into wire 15 to produce twenty-four volts, then the DU microprocessor 50 has this information in its memory, takes into account he voltage drops across connectors 28 and 17A, across bulkhead conenctor 67, and across connectors 18A and 59, and expects sensor unit 52 to detect a voltage of something less than twenty-four volts. If sensor unit 52 detects the appropriate voltage, microprocessor 50 commands light 62 to illuminate. If sensor unit 52 detects a voltage across wire 15 which is less than the expected votlage, then microprocessor will not command light 62 to illuminate.

(5)    The Full Load Test button 54 is in the "ON" position.

RESULT:    Based on the results of the full load test of Steps 5-8 above, the technician knows that wire 15 has the expected conductive continuity along its enitre length, i.e., knows that there are no loose bulkhead connections or other loose connections along wire 15.

SUBSEQUENT MAINTENANCE PROCEDURE: Proceed to testing of any remaining wires. Wire 16 would be tested in the same manner described above in Steps 3-8 for wire 15, with similar results. The full load test of wire 16 would confirm that wire 16 had the expected conductive continuity along its entire length.

## TABLE II

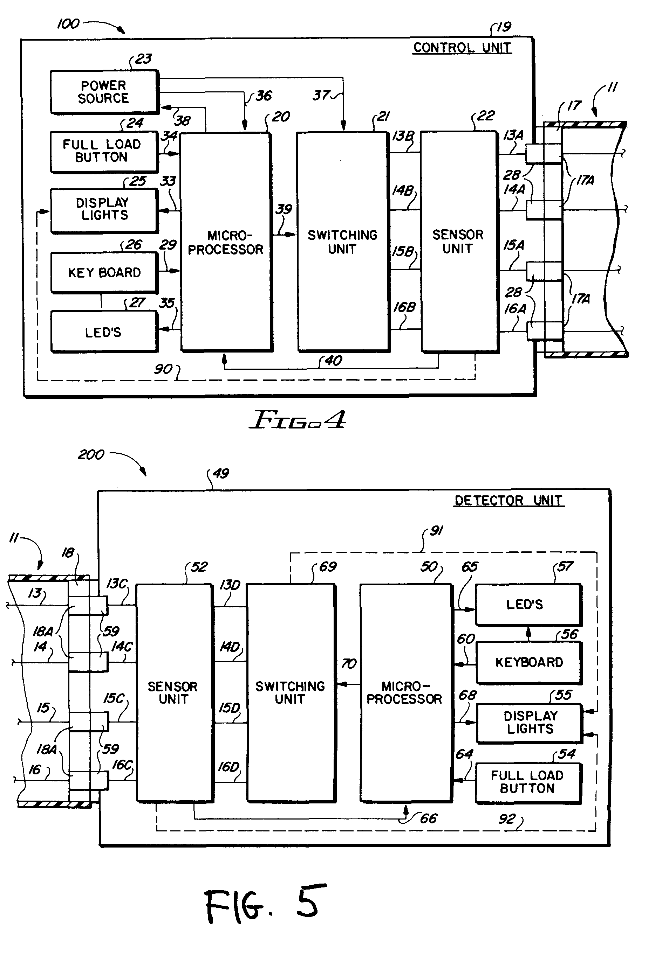

Test Procedure for Cable 11 of Fig. 2. Wires 14-16 Continuous; Wire 13 Severed; and, Wire 14 Shortened to Wire 13

Step 1: This is identical to Step 1 in Table I

Step 2: This is identical to Step 2 in Table I, excepting that since wire 13 is severed, the signal directed into wire 13 by CU 100 never reaches wire 13C of DU 200 and the signal 66 from sensor unit 52 to DU microprocessor 50 indicates a small current flowing through line 14C and no current flowing through lines 13C, 15C and 16C. The readings on the CU 100 and DU 200 after Steps 1 and 2 immediately above are identical to the readings on the CU and DU in TABLE I after Steps 1 and 2 therein, except that on the DU 200:

(1) LED readout 57 reads, in sequence: "SS 14"

(2) Amber indicator light 63 is off.

RESULT: Based on the above readings, the technician utilizing the testing equipment of the invention knows that wire 14 is shorted to wire 13, that wire 14 has a minimal amount of conductivity and it not severed, and that wire 13 is severed.

SUBSEQUENT MAINTENANCE PROCEDURE: The subsequent maintenance procedure is identical to that noted in TABLE I after Steps 1 and 2

Steps 3-8: Steps 3-8 are identical to those of TABLE I. The CU 100 and DU readouts, RESULTS, and

SUBSEQUENT MAINTENANCE PROCEDURE for Steps 3-8 in TABLE II are identical to those for Steps 3-8 in TABLE I.

NOTE:    In the event of a short to ground microprocessor 20 of CU 100 automatically terminates the test of a wire. For example, if wire 16 were shorted to ground, then when buttons "1" and "6" are pushed on keyboard 26, the microprocessor 20 commands switching unit 21 to direct a current from power source 23 into wire 16A. If the current exceeds 100 ma, microprocessor 20 terminates the test of wire 16. When the microprocessor 20 terminates the test of wire 16 because of a dead short, the CU 100 readouts are:

a.    LED readout 27 reads, in sequence: "DS 16". (DS - dead short).

b.    Red indicator light 30 is off.

c.    Green indicator light 31 is on.

d.    Amber indicator light is off.

e.    Full Load Test button 24 is in the "OFF" position.

As in the case when one wire 13-16 is shorted to another wire 13-16, microprocessor 20 inhibits a full load check when a wire 13-16 is shorted to ground.

---

EP 0 235 907 B1

TABLE III

Test Procedure for Cable 11 of Fig. 3. Wires 13-16
Severed.

Step 1:        Step 1 is identical to Step 1 in TABLE I.
Step 2:        The technical grasps a wire extending from
               DU 200 and touches it to a wire extending
               from CU 100. The technician can only see the
               severed ends of wires extending from DU 200
               and CU 100 and does not know the identity of
               any of the wires. For purposes of this
               discussion it is assumed the technician
               grasped wire 14 extending from DU 200 and
               touched it to wire 13 extending from CU 100.
Step 3:        The "1" and "3" buttons are sequentially
               depressed on keyborad 56 of detector unit
               (DU) 200. When the "1" and "3" buttons are
               depressed, the small current directed into
               wire 13 by CU 100 travels along wire 13
               extending from CU 100, into wire 14
               extending from DU 200, through connectors
               18A and 59, and into sensor unit 52. Signal
               66 from sensor unit 52 to DU microprocessor
               50 indicates that a small current is flowing
               through lines 13C, 15C and 16C. Sensor unit
               22 of CU 100 informs 40 microprocessor 20
               that a small current is flowing through
               lines 13A and that no current is flowing
               through lines 14A-16A. After receiving the
               afore-mentioned data, microprocessors 20 and
               50 direct 35, 65 LED readouts 27 and 57,
               respectively, and direct 33, 58 display
               lights 25, 55 to read as indicated below.
        a. Readings on control unit (CU) 100:

17

(1)    LED readout 27 reads, in sequence: "PT 13".

(2)    Red indicator light 30 is off.

(3)    Green indicator light 31 is on.

(4)    Amber indicator light 32 is off.

(5)    The Full Load Test button 24 is in the "OFF" position.

b. Readings on detector unit (DU) 200:

(1)    LED readout 57 reads, in sequence: "SS 14".

(2)    Red indicator light 61 is on.

(3)    Amber indicator light 63 is off.

(4)    Green indicator light 62 is off.

(5)    The Full Load Test Button 54 is in the "OFF" position.

RESULT:    Based on the readouts on CU 100 and DU 200 following Step 4 above, the technician knows that the CU wire he has touched is wire 13 and knows that the DU wire touching CU wikre 13 is wire 14.

SUBSEQUENT MAINTENANCE PROCEDURE: The technician marks wire 13 extending from the control unit 100, and marks wire 14 extending from the detector unit 200.

Step 4:    Buttons "1" and "4" are sequentially pushed both on keyboard 26 and keyboard 56, and wire 14 extending from DU 200 is touched to the remaining unidentified wires extending from CU 100 until the reading "SP 14" appears on LED readout 57. When "SP 14" appears on readout 57, then wire 14 extending from DU 200 has been touched to wire 14 extending from CU 100. The technician marks wire 14 extending from CU 100.

Step 5:    Buttons "1" and "5" are sequentially pushed both on keyboard 26 and keyboard 56 and wire 14 extending from DU 200 is touched to the

18

remaining unidentified wires extending from CU 100 until the reading "SS 14" appears on readout 57. When "SS 14" appears on readout 57, then wire 14 extending from DU 200 has been touched to wire 15 extending from CU 100. The technician marks wire 15 extending from the CU 100, and, also marks the remaining wire extending from CU 100 as wire 16.

Step 6:     Wire 15 from CU 100 is touched to each of the remaining unidentified wires extending from DU 200 to identify these wires. As would be appreciated by those of skill in the art from the foregoing descriptions herein, each time wire 15 is touched to one of the remaining unidentified wires extending from DU 200, one of the following readings will appear on LED readout 57; "SP 15", "SS 14" or "SS 16". Each of the remaining wires extending from DU 200 is mared when it is identified.

Step 7:     Wire 14 extending from CU 100 is attached to wire 14 extending from DU 200; wire 15 extending from CU 100 is attached to wire 15 extending from DU 200; wire 16 is extending from CU 100 is attached to wire 16 extending from DU 200; and, wire 13 extending from CU 100 is attached to wire 13 extending from DU 200. After the wires are attached, each wire is given a full load test to insure the wires have the desired conductive continuity.

---

CU 100 and DU 200 can be constructed from existing off-the-shelf electronic components and can, depending on the size of a cannon plug 17, 18, often be sized to be carried in the pocket of an individual. It is anticipated that each CU 100--DU 200 pair will be constructed for testing a cable which is built to carry a certain current and voltage and has cannon plugs or other connector means of a particular shape and dimension. The connectors 28, 59 on the CU and DU would be constructed to readily mate with the cable cannon plugs or other connector means to provide cable--CU and cable--DU interfaces having the proper conductive continuity. Structure and other information peculiar to a cable, for instance the existance of built-

EP 0 235 907 B1

in jumpers between wires, would be programmed into the microprocessors provided in CU 100 and DU 200.

While the transmission lines used to transmit electromagnetic radiation are, in the drawings and in TABLES I-III, described as electrically conductive wires, the lines can be constructed as appropriate to carry other types of energy. For example, transmission line 12 can be a fiber optic cable for conducting light or can be a hollow tube for conducting heat or radio waves.

CU 100 and DU 200 need not include microprocessors in order to function in accordance with the invention. CU 100 can comprise a mechanical switch which can connect a line or wire being tested to a battery or other power source. DU 200 can comprise a mechanical switch which can connect the line or wire being tested with an appropriate load and an indicator light(s). The DU would include means for individuallly checking or simultaneously monitoring each wire or line in a cable to determine if current is present in the lines when a signal is sent by the CU over the line being tested. For example, in Fig. 4 microprocessor 20, LED readout 27, and keyboard 26 can be eliminated. Switching unit 21 can include a mechanical switch which, when rotated to the wire 13-16 being tested, permits current from power source 23 to only flow over the wire being tested. Sensor unit 22 can include a switch which causes current on any wire other than the wire being tested to flow 90 to and illuminate stray signal indicator 30. In place of or in addition to indicator 30 there can be an indicator light connected to each wire 13-16 so that the particular wire carrying the stray signal can be identified. The indicator light for each wire would illuminate when current passed through the wire. In Fig. 5, microprocessor 50, LED readout 57, and keyboard 56 can be eliminated. Switching unit 69 can include a mechanical switch which, when rotated to the wire being tested, permits current flowing through the wire being tested to flow 91 to and illuminate amber continuity indicator 63. Sensor unit 52 can include a mechanical switch which causes current on any wire other than the wire being tested to flow 92 to stray signal indicator 61. In place of or in addition to indicator 61 there can be an indicator light connected to each wire 13-16 so that the particular wire carrying the stray signal can be identified. The indicator light for each wire would illuminate when current flowed through the wire.

If desired, means can be provided for transmitting from the CU microprocessor 20 to the DU microprocessor 50 either the identify of the wire being tested on the CU or other information.

As noted, during the full load test, the DU microprocessor 50 monitors sensor unit 52. Sensor unit 52 detects the voltage in the wire being tested. Microprocessor 50 can, if desired, be programmed to cause LED readout 57 to display either the voltage or the voltage drop in the wire being tested. A user, when an aircraft of other machine or device is functioning properly or is new, uses the CU 100 and DU 200 to determine the voltage drop or other measurable characteristic in each wire in each cable in the device. This "voltage drop calibration-reference data base" is retained in the maintenance records of the aircraft. When there subsequently is a malfunction or a periodic maintenancing of the aircraft which requires the voltage drop in a wire to be remeasured, the new measurement is compared with the voltage drop calibraction-reference data on the wire. This comparison of new data with the voltage drop calibraction-reference data is crucial to the proper mantenance of an aircraft and greatly facilitates troubleshooting of malfunctions and the early detection of flaws in a cable. Further, flaws in a cable are often detected during the initial testing of a cable to generate the voltage drop calibration-reference data base.

## Claims

1. A maintenance system for detecting, in each of a plurality of cables (11), faults which cause attenuation of electromagnetic radiation transmitted through the cable, each of said cables including a plurality of lines (13-16) extending the length of the cable, each of said cables having a first end including first connector means (17) and having a second end including second connector means (18), each of said plurality of lines terminating at said first and second connector means, each of said first and second connector means normally being removably connected to mating means in a system, each of said connector means being disconnected from said mating means during utilization of said maintenance system, said maintenance system including:

   (a) a transportable control unit (100) including:

      (i) means (28) for attaching said control unit to said first connector means (17) of a selected one of said cables to connect said control unit and the selected cable, and

      (ii) control means (20, 21, 22, 23, 24, 26) for selectively directing continuity evaluation electromagnetic radiation into a selected one of said lines at said first end of the selected cable,

   (b) a transportable detector unit (200) including:

      (i) means (59) for attaching said detector unit to said second connector means (18) of the selected cable (11) to connect said detector unit and the selected cable, and

20

EP 0 235 907 B1

(ii) sensor means (52) for measuring the quantity of electromagnetic radiation reaching said second end of the selected cable in each of said lines when said control means directs said continuity evaluation electromagnetic radiation into said selected line at said first end of the selected cable, said sensor means measuring continuity evaluation-fault detection information for each of said lines when said control means directs said continuity evaluation electromagnetic radiation into said selected line at said first end of the selected cable,

(iii) storage means (50) for storing continuity evaluation-reference information which serves to indicate which of said second ends of the lines should normally produce an output of transmitted electromagnetic radiation when said first quantity of electromagnetic radiation is directed into said lines at said first end of said plurality of cables, said storage means including means for recalling said continuity evaluation-reference information stored therein for each of said lines; and

(iv) comparison means (50) coupled to said sensor means and coupled to said storage means for comparing said continuity evaluation-fault detection information with said recalled reference measurement information and generating continuity fault-identification information (63) in response to such comparison;

said maintenance system being characterised in that:

(c) said continuity evaluation electromagnetic radiation is relatively minimal in degree by comparison to the amount of electromagnetiC radiation normally conducted by each of said lines of the selected cable under normal load conditions and serving merely to confirm that such electromagnetic radiation reaches the second end of the selected cable;

(d) said control means (20,21,22,23,24,26) is also operable selectively to direct load evaluation electromagnetic radiation into said selected line at said first end of the selected cable, said load evaluation electromagnetic radiation being relatively similar in degree to the amount of electromagnetic radiation normally conducted by each of said lines of the selected cable under normal load conditions;

(e) said sensor means (52) also measuring load evaluation fault detection information for each of said lines when said control means directs said load evaluation electromagnetic radiation into said selected line at said first end of the selected cable;

(f) said storage means (50) also storing as load evaluation-reference information for each of said lines, nominal quantities of electromagnetic radiation measured for each of said lines at said second end of a plurality of said cables when said load evaluation electromagnetic radiation is directed into said lines at said first end of said plurality of identical cables, said storage means including means for recalling said load evaluation-reference information stored therein for each of said lines; and

(g) said comparison means (50) also comparing said load evaluation-fault detection information with said recalled load evaluation-reference measurement information and generating load fault-identification information (62) in response to such comparison

2. A method of detecting, in each of a plurality of cables (11), faults which cause attenuation of electromagnetic radiation transmitted through the cable, each of said cables including a plurality of lines (13-16) extending the length of the cable, each of said cables having a first end including first connector means (17) and having a second end including second connector means (18), each of said plurality of lines terminating at said first and second connector means, each of said first and second connector means normally being removably connected to mating means in a system, said method including the steps of:

(a) generating continuity evaluation-reference measurement information for said cables by:

(i) detaching said first and second connector means (17,18) for a plurality of said cables (11) from said mating means;

(ii) directing continuity evaluation electromagnetic radiation into each of said lines of said cables at said first end of each cable at said first connector means thereof to generate continuity evaluation-reference information for each of said lines of said cables at the second ends thereof, (iii) determining which of said second ends of said lines for each of said cables at said second connector means thereof produce an output of transmitted electromagnetic radiation when said continuity evaluation electromagnetic radiation is directed into said lines at said first end of each cable, said determination providing continuity evaluation-reference information for each line of said plurality of cables;

(iv) storing said continuity evaluation-reference information;

(b) generating continuity evaluation-fault detection information in a selected one of said cables by:

21

(i) detaching said first and second connector means of said selected cable from said mating means;

(ii) directing through each of said lines in said selected cable said continuity evaluation electromagnetic radiation;

(iii) determining continuity evaluation-fault detection information by establishing which of said lines at said second end of the selected cable produce an output of electromagnetic radiation when said continuity evaluation electromagnetic radiation is directed into said lines in Step (b) (ii); and (iv) recalling said continuity evaluation-reference information and comparing said continuity evaluation-reference information with said continuity evaluation-fault detection information to generate continuity fault-identification information, said continuity fault-identification information identifying variances between said continuity evaluation-reference information and said continuity evaluation-fault detection information;

said method being characterised in that said continuity evaluation electromagnetic radiation being relatively minimal in degree by comparison to the amount of electromagnetic radiation normally conducted by each of said lines of said identical cables under normal load conditions and serving merely to confirm that such electromagnetic radiation reaches the second end of each such cable, and the further step of:

(c) generating load evaluation-reference measurement information for said cables by:

(i) detaching said first and second connector means for a plurality of said identical cables from said mating means;

(ii) directing a load evaluation electromagnetic radiation into each of said lines of said cables at said first end of each cable at said first connector means thereof to generate load evaluation-reference information for each of said lines of said cables at the second ends thereof, said load evaluation electromagnetic radiation being relatively similar in degree to the amount of electromagnetic radiation normally conducted by each of such lines of said cables under normal load conditions;

(iii) measuring the quantity of electromagnetic radiation reaching said second end of the cable in each of said lines for each of said identical cables at said second connector means thereof when said load evaluation electromagnetic radiation is directed into said lines at said first end of each cable, said measured quantity representing load evaluation-reference information, for each line of said plurality of cables;

(iv) storing as load evaluation-reference information the quantity of electromagnetic radiation measured at said second ends of the cable when said second load evaluation of electromagnetic radiation is directed into said lines in Step (c) (ii) above;

(d) generating load evaluation-fault detection information in a selected one of said cables by:

(i) detaching said first and second connector means of said selected cable from said mating means;

(ii) directing through each of said lines in said selected cable said load evaluation electromagnetic radiation;

(iii) measuring as load evaluation-fault detection information the quantities of electromagnetic radiation measured in said lines at said second end of said selected cable when said load evaluation electromagnetic radiation is directed into said lines in Step (d) (ii) above and

(iv) recalling said load evaluation-reference information and comparing said load evaluation-reference information with said load evaluation-fault detection information to generate load fault-identification information, said load fault-identification information identifying variances between said load evaluation-reference information and said load evaluation-fault detection information.

3. The maintenance system of claim 1, wherein said continuity evaluation electromagnetic radiation is an electrical current in a range of approximately 3 milliamps to 30 milliamps.

4. The method of claim 2, wherein said continuity evaluation electromagnetic radiation is an electrical current in a range of approximately 3 milliamps to 30 milliamps.

5. The maintenance system of claim 3, wherein said load evaluation electromagnetic radiation is an electrical current in a range of approximately three to ten amps.

6. The method of claim 4, wherein said load evaluation electromagnetic radiation is an electrical current in a range of approximately three to ten amps.

**Patentansprüche**

1. Wartungssystem, um in jedem einer Anzahl von Kabeln (11) Störungen festzustellen, die eine Dämpfung von über das Kabel übertragener elektromagnetischer Strahlung herbeiführen, wobei jedes der Kabel eine Vielzahl von über die Länge des Kabels verlaufenden Leitungen (13-16) aufweist, jedes der Kabel ein erstes Ende mit ersten Anschlußmitteln (17) und ein zweites Ende mit zweiten Anschlußmitteln (18) umfaßt, jede der Vielzahl von Leitungen an den ersten und zweiten Anschlußmitteln endet, jedes der ersten und zweiten Anschlußmittel normalerweise abnehmbar oder trennbar mit angepaßten Mitteln in einem System verbunden ist, jedes der Anschlußmittel bei der Anwendung des Wartungssystems von den angepaßten Mitteln getrennt wird, wobei das Wartungssystem umfaßt:

(a) eine transportable oder tragbare Steuereinheit (100) mit:

(i) Mitteln (28) zum Anbringen der Steuereinheit an den ersten Anschlußmitteln (17) eines ausgewählten der Kabel zwecks Verbindung der Steuereinheit mit dem ausgewählten Kabel und (ii) eine Steuereinheit (20, 21, 22, 23, 24, 26) zum selektiven Richten von elektromagnetischer Kontinuitätsauswertungsstrahlung in eine ausgewählte der Leitungen am ersten Ende des ausgewählten Kabels,

(b) eine transportable oder tragbare Detektoreinheit (200) mit:

(i) Mitteln (59) zum Anbringen der Detektoreinheit an den Zweiten Anschlußmitteln (18) des ausgewählten Kabels zwecks Verbindung der Detektoreinheit mit dem ausgewählten Kabel und

(ii) einer Sensoreinheit (52) zum Messen der Größe der elektromagnetischen Strahlung, die das zweite Ende des ausgewählten Kabels in jeder der Leitungen erreicht, wenn die Steuereinheit die elektromagnetische Kontinuitätsauswertungsstrahlung am ersten Ende des ausgewählten Kabels in die ausgewählte Leitung richtet, wobei die Sensoreinheit Kontinuitätsauswertungs-Störungserfassungsinformation für jede der Leitungen mißt, wenn die Steuereinheit die elektromagnetische Kontinuitätsauswertungsstrahlung am ersten Ende des ausgewählten Kabels in die ausgewählte Leitung richtet,

(iii) einer Speichereinheit (50) zum Speichern von Kontinuitätsauswertungs-Bezugsinformation, die zur Anzeige dient, welches der zweiten Enden der Leitungen normalerweise ein Ausgangssignal der übertragenen elektromagnetischen Strahlung erzeugen sollte, wenn die erste Größe der elektromagnetischen Strahlung am ersten Ende der Vielzahl von Kabeln in die Leitungen gerichtet wird, wobei die Speichereinheit Mittel zum Abrufen der darin gespeicherten Kontinuitätsauswertungs-Bezugsinformation für jede der Leitungen aufweist, und

(iv) einer mit der Sensoreinheit und mit der Speichereinheit verbundenen Vergleichereinheit (50) zum Vergleichen der Kontinrnitätsauswertungs-Störungserfassungsinformation mit der abgerufenen Bezugsmeßinformation und zum Erzeugen einer Kontinuitätsstörungs-Identifizierinformation (63) in Abhängigkeit von diesem Vergleich,

wobei das Wartungssystem
dadurch gekennzeichnet ist, daß

(c) die elektromagnetische Kontinuitätsauswertungsstrahlung größenmäßig vergleichsweise minimal ist im Vergleich zur Menge der elektromagnetischen Strahlung, die normalerweise durch jede der Leitungen des ausgewählten Kabels unter normalen Lastbedingungen geleitet wird, und lediglich zur Bestätigung dient, daß diese elektromagnetische Strahlung das zweite Ende des ausgewählten Kabels erreicht,

(d) die Steuereinheit (20, 21, 22, 23, 24, 26) auch selektiv betätigbar ist, um am ersten Ende des ausgewählten Kabels in die ausgewählte Leitung elektromagnetische Lastauswertungsstrahlung zu richten, welche größenmäßig der Menge an elektromagnetischer Strahlung vergleichsweise ähnlich ist, welche durch jede der Leitungen des ausgewählten Kabels unter normalen Lastbedingungen normalerweise geleitet wird,

(e) die Sensoreinheit (52) auch Lastauswertungs-Störungserfassungsinformation für jede der Leitungen mißt, wenn die Steuereinheit die elektromagnetische Lastauswertungsstrahlung am ersten Ende des ausgewählten Kabels in die ausgewählte Leitung richtet,

(f) die Speichereinheit (50) auch als Lastauswertungs-Bezugsinformation für jede der Leitungen Nenngrößen der für jede der Leitungen am zweiten Ende einer Vielzahl der Kabel gemessenen elektromagnetischen Strahlung speichert, wenn die elektromagnetische Lastauswertungsstrahlung am ersten Ende der Vielzahl identischer Kabel in die Leitungen gerichtet wird, wobei die Speichereinheit Mittel zum Abrufen der darin für jede der Leitungen gespeicherten Lastauswertungs-Bezugsinformation aufweist, und

EP 0 235 907 B1

(g) die Vergleichereinheit (50) auch die Lastauswertungs-Störungserfassungsinformation mit der abgerufenen Lastauswertungs-Bezugsmeßinformation vergleicht und in Abhängigkeit von diesem Vergleich eine Laststörungsidentifizierungsinformation (62) erzeugt.

2. Verfahren, um in Jedem einer Anzahl von Kabeln (11) Störungen festzustellen, die eine Dämpfung von über das Kabel übertragener elektromagnetischer Strahlung herbeiführen, wobei jedes der Kabel eine Vielzahl von über die Länge des Kabels verlaufenden Leitungen (13-16) aufweist, jedes der Kabel ein erstes Ende mit ersten Anschlußmitteln (17) und ein zweites Ende mit zweiten Anschlußmitteln (18) umfaßt, jede der vielzahl von Leitungen an den ersten und zweiten Anschlußmitteln endet, jedes der ersten und zweiten Anschlußmittel normalerweise abnehmbar oder trennbar mit angepaßten Mitteln in einem System verbunden ist, wobei das Verfahren folgende Schritte umfaßt:

(a) Erzeugen von Kontinuitätsauswertungs-Bezugsmeßinformation für die Kabel durch:

(i) Abtrennen der ersten und zweiten Anschlußmittel (17, 18) für eine Vielzahl der Kabel (11) von den angepaßten Mitteln,

(ii) Richten von elektromagnetischer Kontinuitätsauswertungsstrahlung in jede der Leitungen der Kabel am ersten Ende jedes Kabels an dessen ersten Anschlußmitteln zwecks Erzeugung von Kontinuitätsauswertungs-Bezugsinformation für jede der Leitungen der Kabel an den Zweiten Enden derselben,

(iii) Bestimmen, welches der zweiten Enden der Leitungen für jedes der Kabel an den zweiten Anschlußmitteln ein Ausgangssignal übertragener elektromagnetischer Strahlung erzeugt, wenn die elektromagnetische Kontinuitätsauswertungsstrahlung am ersten Ende jedes Kabels in die Leitungen gerichtet wird, wobei die Bestimmung eine Kontinuitätsauswertungs-Bezugsinformation für jede Leitung der Vielzahl von Kabeln liefert,

(iv) Speichern der Kontlnuitätsauswertungs-Bezugsinformation,

(b) Erzeugen von Kontinuitätsauswertungs-Störungserfassungsinformation in einem ausgewählten der Kabel durch:

(i) Abtrennen der ersten und zweiten Anschlußmittel des ausgewählten Kabels von den angepaßten Mitteln,

(ii) Richten der elektromagnetischen Kontinuitätsauswertungsstrahlung durch jede der Leitungen im ausgewählten Kabel,

(iii) Bestimmen von Kontinuitätsauswertungs-Störungserfassungsinformation durch Feststellung, welche der Leitungen am zweiten Ende des ausgewählten Kabels ein Ausgangssignal elektromagnetischer Strahlung erzeugt, wenn die elektromagnetische Kontinuitätsauswertungsstrahlung im Schritt (b) (ii) in die Leitungen gerichtet wird, und

(iv) Abrufen der Kontinuitätsauswertungs-Bezugsinformation und Vergleichen derselben mit der Kontinuitätsauswertungs-Störungserfassungsinformation zwecks Erzeugung von Kontinuitätsstörungs-Identifizierungsinformation, weiche Varianzen zwischen der Kontinuitätsauswertungs-Bezugsinformation und der Kontinuitätsauswertungs-Störungserfassungsinformation identifiziert,

wobei das Verfahren

dadurch gekennzeichnet ist,

daß die elektromagnetische Kontinuitätsauswertungsstrahlung größenmäßig vergleichsweise minimal ist im Vergleich zur Menge der elektromagnetischen Strahlung, die normalerweise durch jede der Leitungen der identischen Kabel unter normalen Lastbedingungen geleitet wird, und die lediglich zur Bestätigung dient, daß diese elektromagnetische Strahlung das zweite Ende jedes dieser Kabel erreicht, sowie den weiteren Schritt:

(c) Erzeugen von Lastauswertungs-Bezugsmeßinformation für die Kabel durch:

(i) Abtrennen der ersten und zweiten Anschlußmittel für eine Anzahl oder vielzahl der identischen Kabel von den angepaßten Mitteln,

(ii) Richten einer elektromagnetischen Lastauswertungsstrahlung in jede der Leitungen der Kabel am ersten Ende jedes Kabels an den ersten Anschlußmitteln derselben zwecks Erzeugung von Lastauswertungs-Bezugsinformation für jede der Leitungen der Kabel an deren zweiten Enden, wobei die elektromagnetische Lastauswertungsstrahlung größenmäßig vergleichsweise der Menge elektromagnetischer Strahlung ähnlich ist, die normalerweise durch jede dieser Leitungen der Kabel unter normalen Lastbedingungen geleitet wird,

(iii) Messen der Menge der das zweite Ende des Kabels erreichenden elektromagnetischen Strahlung in jeder der Leitungen für jedes der identischen Kabel an dessen zweiten Anschlußmitteln, wenn die elektromagnetische Lastauswertungsstrahlung in die Leitungen am ersten Ende

24

EP 0 235 907 B1

jedes Kabels gerichtet wird,wobei die Meßgröße die Lastauswertungs-Bezugsinformation repräsentiert, für jede Leitung der Vielzahl von Kabeln,

(iv) Speichern, als Lastauswertungs-Bezugsinformation, der Größe oder Menge der an den zweiten Enden der Kabel gemessenen elektromagnetischen Strahlung, wenn die zweite elektromagnetische Lastauswertungsstrahlung im obigen Schritt (c)

(ii) in die Leitungen gerichtet wird,

(d) Erzeugen von Lastauswertungs-Störungserfassungsinformation in einem ausgewählten der Kabel durch:

(i) Abtrennen der ersten und zweiten Anschlußmittel des ausgewählten Kabels von den angepaßten Mitteln,

(ii) Richten der elektromagnetischen Lastauswertungsstrahlung durch jede der Leitungen im ausgewählten Kabel,

(iii) Messen, als Lastauswertungs-Störungserfassungsinformation, der Mengen der elektromagnetischen Strahlung, die in den Leitungen am zweiten Ende des ausgewählten Kabels gemessen wird, wenn die elektromagnetische Lastauswertungsstrahlung im obigen Schritt (d) (ii) in die Leitungen gerichtet wird, und

(iv) Abrufen der Lastauswertungs-Bezugsinformation und Vergleichen derselben mit der Lastauswertungs-Störungserfassungsinformation zum Erzeugen von Laststörungsidentifizierungsinformation, welche Varianzen zwischen der Lastauswertungs-Bezugsinformation und der Lastauswertungs-Störungserfassungsinformation identifiziert.

3. Wartungssystem nach Anspruch 1, bei dem die elektromagnetische Kontinuitätsauswertungsstrahlung ein elektrischer Strom in einem Bereich von etwa 3 mA bis 30 mA ist.

4. Verfahren nach Anspruch 2, bei dem die elektromagnetische Kontinuitätsauswertungsstrahlung ein elektrischer Strom in einem Bereich von etwa 3 mA bis 30 mA ist.

5. Wartungssystem nach Anspruch 3, bei dem die elektromagnetische Lastauswertungsstrahlung ein elektrischer Strom in einem Bereich von etwa 3 - 10 A ist.

6. Verfahren nach Anspruch 4, bei dem die elektromagnetische Lastauswertungsstrahlung ein elektrischer Strom in einem Bereich von etwa 3 - 10 A ist.

**Revendications**

1. Système de maintenance pour détecter, dans chacun d'une multiplicité de câbles (11), des défauts provoquant une atténuation du rayonnement électromagnétique transmis à travers le câble, chacun de ces câbles comportant une multiplicité de lignes (13-16) s'étendant sur la longueur du câble, chacun de ces câbles ayant une première extrémité comportant un premier connecteur (17) et ayant une deuxième extrémité comportant un deuxième connecteur (18), chacune de ladite multiplicité de lignes se terminant au niveau du premier connecteur et du deuxième connecteur, chacun du premier connecteur et du deuxième connecteur étant normalement raccordé de façon amovible à des moyens conjugués dans un système, chacun desdits connecteurs étant déconnecté de ces moyens conjugués pendant l'utilisation dudit système de maintenance, ce système de maintenance comportant :

(a) une unité de commande transportable (100), contenant :

(i) des moyens (28) pour attacher cette unité de commande au premier connecteur (17) d'un câble choisi parmi la multiplicité de câbles pour raccorder ladite unité de commande et le câble sélectionné; et

(ii) des moyens de commande (20,21,22,23,24,26) pour diriger sélectivement un rayonnement électromagnétique d'évaluation de continuité dans la ligne sélectionnée de la multiplicité de lignes au niveau de la première extrémité du câble sélectionné;

(b) une unité de détection transportable (200) contenant :

(i) des moyens (59) pour attacher ladite unité de détection au deuxième connecteur (18) du câble sélectionné (11) pour raccorder cette unité de détection et le câble sélectionné; et

(ii) des moyens de détection (52) pour mesurer la quantité de rayonnement électromagnétique atteignant la deuxième extrémité du câble sélectionné dans chacune desdites lignes lorsque les moyens de commande dirigent ce rayonnement électromagnétique d'évaluation de continuité dans ladite ligne sélectionnée au niveau de la première extrémité du câble sélectionné, ces

25

moyens de détection mesurant une information de détection de défaut d'évaluation de continuité pour chacune desdites lignes lorsque les moyens de commande dirigent ce rayonnement électromagnétique d'évaluation de continuité dans la ligne sélectionnée au niveau de la première extrémité du câble sélectionné;

(iii) des moyens de stockage (50) pour stocker une information de référence d'évaluation de continuité qui sert à indiquer lesquelles des deuxièmes extrémités des lignes doivent normalement produire une sortie de rayonnement électromagnétique transmis lorsque la première quantité de rayonnement électromagnétique est dirigée dans les lignes au niveau de la première extrémité de la multiplicité de câbles, ces moyens de stockage comportant des moyens pour rappeler cette information de référence d'évaluation de continuité stockée dans les moyens de stockage pour chacune de ces lignes; et

(iv) des moyens de comparaison (50) couplés aux moyens de détection et couplés aux moyens de stockage pour comparer l'information de détection de défaut d'évaluation de continuité à cette information de mesure de référence rappelée et pour produire une information d'identification de défaut de continuité (63) en réponse à une telle comparaison;

ce système de maintenance étant caractérisé en ce que :

(c) le rayonnement électromagnétique d'évaluation de continuité est relativement minimal par rapport à la quantité de rayonnement électromagnétique normalement transmis par chacune des lignes du câble sélectionné dans des conditions de charge normales, ce rayonnement servant simplement à confirmer que ce rayonnement électromagnétique atteint bien la deuxième extrémité du câble sélectionné;

(d) les moyens de commande (20,21,22,23,24,26) peuvent également être mis en oeuvre pour diriger sélectivement un rayonnement électromagnétique d'évaluation de charge dans cette ligne sélectionnée au niveau de la première extrémité du câble sélectionné, ce rayonnement électromagnétique d'évaluation de charge ayant une valeur relativement semblable à la valeur du rayonnement électromagnétique normalement transmis par chacune des lignes du câble sélectionné dans des conditions de charge normales;

(e) les moyens de détection (52) mesurent également une information de détection de défaut d'évaluation de charge pour chacune de ces lignes lorsque les moyens de commande dirigent ce rayonnement électromagnétique d'évaluation de charge dans la ligne sélectionnée au niveau de la première extrémité du câble sélectionné;

(f) les moyens de stockage (50) stockent également en tant qu'information de référence d'évaluation de charge pour chacune de ces lignes des quantités nominales de rayonnement électromagnétique mesurées pour chacune de ces lignes au niveau de la deuxième extrémité d'une multiplicité de ces câbles lorsque le rayonnement électromagnétique d'évaluation de charge est dirigé dans ces lignes au niveau de la première extrémité de cette multiplicité de câbles identiques, les moyens de stockage comportant des moyens pour rappeler l'information de référence d'évaluation de charge stockée dans ces moyens de stockage pour chacune de ces lignes; et

(g) les moyens de comparaison (50) comparent également cette information de détection de défaut d'évaluation de charge avec l'information de mesure de référence d'évaluation de charge rappelée et produisent une information d'identification de défaut de charge (62) en réponse à cette comparaison.

**2.** Méthode pour détecter, dans chacun d'une multiplicité de câbles (11), des défauts provoquant une atténuation d'un rayonnement électromagnétique transmis à travers le câble, chacun de ces câbles comportant une multiplicité de lignes (13-16) s'étendant sur la longueur du câble, chacun de ces câbles ayant une première extrémité comportant un premier connecteur (17) et ayant une deuxième extrémité comportant un deuxième connecteur (18), chacune de cette multiplicité de lignes se terminant au niveau du premier connecteur et du deuxième connecteur, chacun du premier connecteur et du deuxième connecteur étant normalement raccordé de façon amovible à des moyens conjugués dans un système, cette méthode comportant les stades suivants :

(a) produire une information de mesure de référence d'évaluation de continuité pour ces câbles en :

(i) détachant le premier connecteur (17) et le deuxième connecteur (18) pour une multiplicité de ces câbles (11) des moyens conjugués;

(ii) diriger un rayonnement électromagnétique d'évaluation de continuité dans chacune des lignes de ces câbles au niveau de la première extrémité de chaque câble au niveau du premier connecteur de ce câble pour produire une information de référence d'évaluation de continuité pour chacune des lignes de ces câbles au niveau de leurs deuxièmes extrémités;

26

(iii) déterminer lesquelles de ces deuxièmes extrémités de ces lignes pour chacun de ces câbles au niveau du deuxième connecteur doivent produire une sortie de rayonnement électromagnétique transmis lorsque ce rayonnement électromagnétique d'évaluation de continuité est dirigé dans ces lignes au niveau de la première extrémité de chaque câble, cette détermination procurant une information de référence d'évaluation de continuité pour chaque ligne de cette multiplicité de câbles;

(iv) stocker cette information de référence d'évaluation de continuité;

(b) produire une information de détection de défaut d'évaluation de continuité dans un câble sélectionné de cette multiplicité de câbles en :

(i) détachant des moyens conjugués le premier connecteur et le deuxième connecteur de ce câble sélectionné;

(ii) diriger à travers chacune des lignes dans ce câble sélectionné ce rayonnement électromagnétique d'évaluation de continuité;

(iii) déterminer une information de détection de défaut d'évaluation de continuité en établissant lesquelles de ces lignes au niveau de la deuxième extrémité du câble sélectionné produisent une sortie de rayonnement électromagnétique lorsque le rayonnement électromagnétique d'évaluation de continuité est dirigé dans ces lignes au stade (b)(ii); et

(iv) rappeler cette information de référence d'évaluation de continuité et comparer cette information de référence d'évaluation de continuité avec l'information de détection de défaut d'évaluation de continuité pour produire une information d'identification de défaut de continuité, cette information d'identification de défaut de continuité identifiant des variances entre l'information de référence d'évaluation de continuité et l'information de détection de défaut d'évaluation de continuité;

cette méthode étant caractérisée en ce que le rayonnement électromagnétique d'évaluation de continuité est relativement minimal en valeur par rapport à la valeur du rayonnement électromagnétique normalement transmis par chacune de ces lignes de ces câbles identiques dans des conditions de charge normales et en ce qu'il sert simplement à confirmer que le rayonnement électromagnétique atteint la deuxième extrémité de chacun de ces câbles, cette méthode comportant en outre le stade suivant :

(c) produire une information de mesure de référence d'évaluation de charge pour ces câbles en :

(i) détachant des moyens conjugués le premier connecteur et le deuxième connecteur pour une multiplicité de ces câbles identiques;

(ii) diriger un rayonnement électromagnétique d'évaluation de charge dans chacune de ces lignes de ces câbles au niveau de la première extrémité de chaque câble au niveau du premier connecteur pour produire une information de référence d'évaluation de charge pour chacune de ces lignes de ces câbles au niveau de leurs deuxièmes extrémités, ce rayonnement électromagnétique d'évaluation de charge ayant une valeur relativement semblable à la valeur du rayonnement électromagnétique normalement transmis par chacune de ces lignes de ces câbles dans des conditions de charge normales;

(iii) mesurer la quantité de rayonnement électromagnétique atteignant la deuxième extrémité du câble dans chacune de ces lignes pour chacun de ces câbles identiques au niveau de son deuxième connecteur lorsque le rayonnement électromagnétique d'évaluation de charge est dirigé dans ces lignes au niveau de la première extrémité de chaque câble, cette quantité mesurée représentant ladite information de référence d'évaluation de charge pour chaque ligne de cette multiplicité de câbles;

(iv) stocker en tant qu'information de référence d'évaluation de charge la quantité de rayonnement électromagnétique mesurée au niveau des deuxièmes extrémités des câbles lorsque ce deuxième rayonnement électromagnétique d'évaluation de charge est dirigé dans les lignes au stades (c)(ii) ci-dessus;

(d) produire une information de détection de défaut d'évaluation de charge dans un câble sélectionné de cette multiplicité de câbles en :

(i) détachant des moyens conjugués le premier connecteur et le deuxième connecteur de ce câble sélectionné;

(ii) diriger à travers chacune des lignes de ce câble sélectionné ce rayonnement électromagnétique d'évaluation de charge;

(iii) mesurer en tant qu'information de détection de défaut d'évaluation de charge les quantités de rayonnement électromagnétique mesurées dans ces lignes au niveau de la deuxième extrémité du câble sélectionné lorsque le rayonnement électromagnétique d'évaluation de charge est dirigé dans ces lignes au stade (d)(ii) ci-dessus; et

(iv) rappeler l'information de référence d'évaluation de charge et comparer ladite information de référence d'évaluation de charge avec ladite information de détection de défaut d'évaluation de charge pour produire une information d'identification de défaut de charge, cette information d'identification de défaut de charge identifiant des variances entre ladite information de référence d'évaluation de charge et ladite information de détection de défaut d'évaluation de charge.

3. Système de maintenance selon la revendication 1, dans lequel le rayonnement électromagnétique d'évaluation de continuité est un courant électrique dans une plage comprise entre environ 3 milli-ampères et 30 milli-ampères.

4. Méthode selon la revendication 2, dans laquelle le rayonnement électromagnétique d'évaluation de continuité est un courant électrique compris dans une plage d'environ 3 milli-ampères à 30 milli-ampères.

5. Système de maintenance selon la revendication 3, dans lequel le rayonnement électromagnétique d'évaluation de charge est un courant électrique dans une plage comprise entre environ 3 et 10 ampères.

6. Méthode selon la revendication 4, dans laquelle le rayonnement électromagnétique d'évaluation de charge est un courant électrique dans une plage comprise entre environ 3 et 10 ampères.

FIG-1

FIG-2

FIG-3

*FIG.4*

FIG. 5